# EUROPÄISCHE PATENTSCHRIFT

(11) **EP 1 864 333 B1**
(45) Veröffentlichungstag und Bekanntmachung des Hinweises auf die Patenterteilung: **03.02.2010**
(21) Anmeldenummer: 06723877.4
(22) Anmeldetag: 31.03.2006
(51) Int. Cl.: H01L 31/068, H01L 31/0224, H01L 27/142

(54) **Solarzelle**
Solar cell
Cellule solaire

(30) Priorität: 31.03.2005 DE 102005015132
(43) Veröffentlichungstag der Anmeldung: 12.12.2007
(73) Patentinhaber: AZUR SPACE Solar Power GmbH, 74072 Heilbronn (DE)
(72) Erfinder: KÖSTLER, Wolfgang, 74074 Heilbronn (DE); STROBL, Gerhard, 70439 Stuttgart (DE)
(74) Vertreter: Stoffregen, Hans-Herbert
(86) Internationale Anmeldenummer: PCT/EP2006/002914
(87) Internationale Veröffentlichungsnummer: WO 2006/103078

(56) Entgegenhaltungen:
- US-A- 5 009 720
- PATENT ABSTRACTS OF JAPAN Bd. 1995, Nr. 02, 31. März 1995 (1995-03-31) & JP 06 314825 A (TOYODA GOSEI CO LTD), 8. November 1994 (1994-11-08)

## Beschreibung

Die Erfindung bezieht sich auf eine Solarzelle mit Front- und Rückseitenkontakt, zwischen diesen verlaufenden photoaktiven Halbleiterschichten sowie einer frontseitig verlaufenden integralen epitaktisch gewachsenen Schutzdiode mit einer zu der Solarzelle entgegen gerichteten Polarität mit einer solarzellenseitig verlaufenden ersten Halbleiterschicht und einer frontseitig verlaufenden zweiten Halbleiterschicht sowie mit einer frontseitig verlaufenden Metallisierung, die vorzugsweise mit dem Frontseitenkontakt der Solarzelle verbunden ist.

In großflächige Dioden von mehreren Quadratzentimeterflächen, wie diese Solarzellen aus Halbleitermaterial mit wenigstens einem p/n-Übergang bilden, sind Mikrokurzschlüsse, d. h. lokale, kleindimensionierte elektrische (ohmsche) Verbindungen über den p/n-Übergang des Halbleitermaterials oft unvermeidbar. Diese entstehen zum Beispiel durch Oberflächenverletzungen während der Substratherstellung oder durch Dotierstoffanhäufungen zum Beispiel an Kristallstörungen wie Versetzungen, insbesondere bei der Ausbildung von epitaxierten p/n-Übergängen bei zum Beispiel Solarzellen Elemente der Gruppe III - V des Periodensystems.

Normalerweise stören die so entstehenden Mikrokurzschlüsse die Funktion der Diode als Solarzelle in Flussrichtung kaum oder nur in geringem Umfang. Die Fehlstellungen können jedoch bei Betrieb der Zelle in Sperrichtung zu einer Zerstörung der Zelle führen. Sind zum Beispiel mehrere Solarzellen oder -generatoren seriell in einem so genannten String auf einem Solararray miteinander verbunden, so wird bei sperrendem p/n-Übergang eines Generators - dies kann durch Abschattung bewirkt werden - der Solarstrom von der hohen String-Spannung der restlichen beleuchteten Solarzellen oder -generatoren durch die ohmschen Mikro-Kurzschlüsse gepresst. Dies kann zu einer starken lokalen Erhitzung, Umdotierung zur Niederohmigkeit, d. h. lokaler starker Entartung des Halbleiters und letztendlich zur Zerstörung der Zelle selbst führen.

Zur Vermeidung entsprechender lokaler starker Erhitzungen, so genannten Hot-Spots, ist es bei seriell geschalteten Solarzellen bekannt, parallel zu den Solarzellen liegende Schutzdioden (Bypassdioden) anzuordnen, deren Flussrichtung entgegen der der Solarzellen verlaufen.

Aus der EP-A-1 056 137 ist eine Solarzelle der eingangs genannten Art bekannt, bei der die Schutzdiodenhalbleiterschicht bereichsweise von einer Schicht der Solarzelle selbst ausgebildet wird, wobei die photoaktiven Schichten beabstandet zu dem Bereich der Solarzelle verlaufen, der die Schutzdiodenhalbleiterschicht bildet. Die Schutzdiode kann als eine Schottky-Diode, eine MIS-Kontakt-Diode, eine Diode mit p/n-Übergang oder als metalllegierte Diode ausgebildet sein.

Weitere Solarzellen mit Schutzdioden sind der US-A-2002/0179141, der US-B-6 600 100, der US-A-2002/0164834 oder der US-B-6 359 210 zu entnehmen. Bei den entsprechenden Solarzellen kann es sich um so genannte Kaskadensolarzellen handeln, bei denen mehrere Solarzellen übereinander angeordnet und über Tunneldioden voneinander getrennt sind. Die Solarzelle ist vom n/p-Typ. Infolgedessen ist die Schutzdiode vom p/n-Typ. Somit ist die frontkontaktseitige Halbleiterschicht ein Löcherleiter mit der Folge, dass eine Migration der Metallatome des Frontkontaktes erfolgt, wodurch die Diode instabil wird. Eine erhöhte Migration tritt insbesondere dann auf, wenn der Frontkontakt Silber enthält.

Bei gewöhnlichen p/n-Dioden als Schutz- oder Bypassdioden besteht die Gefahr einer Elektromigration, d. h. Metall wandert mit der Stromrichtung von p nach n auf der Oberfläche des Halbleiters mit der Folge, dass es zum Kurzschluss des Bauteils kommen kann.

Der US-A-5,616,185 ist eine Solarzelle mit in einer Ausnehmung der Rückseite eingesetzter getrennt hergestellter Bypassdiode bekannt. Zwischen Bypassdiode und der Solarzelle verläuft eine als Isolator wirkende Haftschicht.

Ein Halbleiterbauelement nach der US-A-4,673,593 weist einen ohmschen Kontakt auf, der aus Schichten aus Ti, Zn, Mo und Au besteht.

In einer Solarzelle nach der US-A-5,009, 720 wird durch Diffusion in ein Si-Substrat ein pn-Übergang ausgebildet.

Aus der JP-A-06 314 825 ist eine Leucht diode bekannt, bei der um eine Elektrode eine isolierende Schicht verläuft.

Der vorliegenden Erfindung liegt die Aufgabe zu Grunde, eine Solarzelle der eingangs genannten Art so weiterzubilden, dass eine Zerstörung der Schutzdiode durch Migration unterbunden wird.

Zur Lösung der Aufgabe sieht die Erfindung im Wesentlichen vor, dass zwischen der Metallisierung und der epitaktisch auf der Solarzelle gewachsenen Schutz- bzw. Bypassdiode eine epitaktisch gewachsene Elektromigrationsbarriere ausgebildet ist. Insbesondere wird vorgeschlagen, dass die Metallisierung die monolithische Schutzdiode kontaktiert und peripher von einer weiteren Halbleiterschicht umgeben ist, die mit der frontseitigen Halbleiterschicht der Schutzdiode eine zweite Diode mit zu der Schutzdiode entgegengesetzter Polarität bildet. Alternativ wird vorgeschlagen, dass auf der Schutzdiode eine Tunneldiode verläuft, auf der eine weitere eine schutzdiodenseitig verlaufende erste Halbleiterschicht und eine frontseitig verlaufende zweite Halbleiterschicht aufweisende Diode einer Polarität angeordnet ist, die der der Schutzdiode entspricht, und dass die Metallisierung mit der schutzdiodenseitig verlaufenden ersten Halbleiterschicht kontaktiert und peripher von der zweiten Halbleiterschicht umgeben ist.

Als Variation kann auf die frontseitig verlaufende zweite Halbleiterschicht der über der Tunneldiode angeordneten Schutzdiode eine Halbleiterschicht aufgetragen werden, die der auf der Tunneldiode verlaufenden Halbleiterschicht entspricht, so dass die Metallisierung von eine Diode bildenden Halbleiterschichten umgeben ist, die eine der Schutzdioden entgegen gerichtete Polarität aufweist.

Erfindungsgemäß ist vorgesehen, dass frontseitig auf der epitaktisch gewachsenen . Schutzdiode zumindest eine die Metallisierung zumindest abschnittsweise rahmenartig umgebende n-, p- oder p/n-Schicht verläuft, die unmittelbar oder über eine oder mehrere Zwischenschichten die Schutzdiode kontaktiert. Sämtliche Schichten sind epitaktisch gewachsen. Die Metallisierung kann die rahmenartig verlaufende Schicht bzw. die Schichten kontaktieren oder beabstandet zu dieser bzw. diesen verlaufen. Des Weiteren besteht die Möglichkeit, dass sich die Metallisierung zumindest abschnittsweise entlang frontseitig verlaufendem Bereich der rahmenartig verlaufenden Schicht bzw. Schichten erstreckt.

Bei der Schutzdiode handelt es sich insbesondere um eine p/n-Diode, so dass infolgedessen die weitere Halbleiterschicht n-leitend ist und die Metallisierung vorzugsweise rahmenartig umgibt.

Wird auf der Schutzdiode eine zweite weitere Diode aufgetragen, die mit der Schutzdiode über die Tunneldiode kontaktiert ist, verläuft die Metallisierung auf der n-leitenden Halbleiterschicht der weiteren Diode und ist von der p-leitenden Halbleiterschicht rahmenartig umgeben.

Des Weiteren besteht die Möglichkeit, dass auf die p-leitende Schicht der zweiten Diode eine n-leitende Schicht aufgebracht wird, so dass die Metallisierung, d. h. der Metallkontakt von einer n/p-Schicht umgeben wird.

Durch die diesbezüglichen Maßnahmen kann der Strom nicht mehr von der Metallisierung über die Oberfläche fließen, sondern nur unter der Metallisierung in den Halbleiter.

Hierdurch wird eine Elektromigration des Metalls ausgeschlossen. Dabei kann die Metallisierung die diese umgebende Halbleiterschicht auch teilweise überlappen, ohne dass die erfindungsgemäßen Vorteile verlassen werden.

Anzumerken ist des Weiteren, dass jede oder einige der die Migration verhindernden bzw. hemmenden Schichten selbst mehrschichtig aufgebaut sein können.

Des Weiteren werden zum Ausbilden der rahmenartigen Struktur Ätzstoppschichten aufgetragen, um die entsprechenden Kontaktschichten für die Metallisierung freizulegen. Bei den Ätzstoppschichten handelt es sich um weitere Halbleiterschichten aus von den darüber liegenden Schichten abweichenden Materialzusammensetzungen.

Insbesondere sieht die Erfindung vor, dass die Solarzelle eine Kaskadensolarzelle wie Triple-Zelle mit übereinander angeordneter ersten, zweiten und dritten Teilsolarzelle des Typs n/p ist, dass zwischen den jeweiligen Teilsolarzellen eine Tunneldiode verläuft, dass die Solarzelle in einen photoaktiven ersten Bereich und einen die Schutzdiode frontseitig aufweisenden zweiten Bereich unterteilt ist, dessen halbleitende Schichten beabstandet zu dem von einem gemeinsamen Substrat ausgehenden photoaktiven ersten Bereich verlaufen.

Dabei sind insbesondere die Teilsolarzellen derart ausgelegt, dass diese Strahlung unterschiedlicher Wellenlänge absorbieren. So kann die erste oder Bodenzelle eine Germaniumsolarzelle sein, über die eine Mittelzelle des Typs Ga₁₋ₓInₓAs mit 0,01 ≤ x ≤ 0,03 verläuft. Frontseitig ist bevorzugterweise eine Ge_{1-y}In_{y}P-Zelle vorgesehen, wobei 0,48 ≤ y ≤ 0,50 ist.

Die entsprechenden Solarzellen sind geeignet, Strahlung der Wellenlänge 900 nm bis 1800 nm (Bodenzelle), 660 nm bis 900 nm (Mittelzelle) bzw. 300 nm bis 660 nm (Front- bzw. Topzelle) zu absorbieren.

Unabhängig hiervon ist insbesondere vorgesehen, dass die Schutzdiode aus einer solarzellenseitig verlaufenden n-Schicht und einer frontseitig verlaufenden p-leitenden Schicht besteht, die jeweils aus Ga₁₋ₓInₓAs mit 0,01 ≤ x ≤ 0,03 bestehen.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung eines der Zeichnung zu entnehmenden bevorzugten Ausführungsbeispiels.

Es zeigen:
- Fig. 1: eine Prinzipdarstellung einer Solarzelle mit Schutzdiode mit einer ersten Ausfiihrungsform einer Elektromigrationsbarriere,
- Fig. 2: eine Prinzipdarstellung einer Solarzelle mit Schutzdiode mit einer zweiten Ausführungsform einer Elektromigrationsbarriere,
- Fig. 3: eine weitere Ausführungsform einer Solarzelle mit Schutzdiode sowie Elektromigrationsbarriere,
- Fig. 4 - 6: Prinzipdarstellungen von Anordnungen von Metallisierungen und diese um- gebenden rahmenartigen Barrieren und
- Fig. 7: einen Aufbau einer Triple-Zelle in ihrem photoaktiven Bereich.

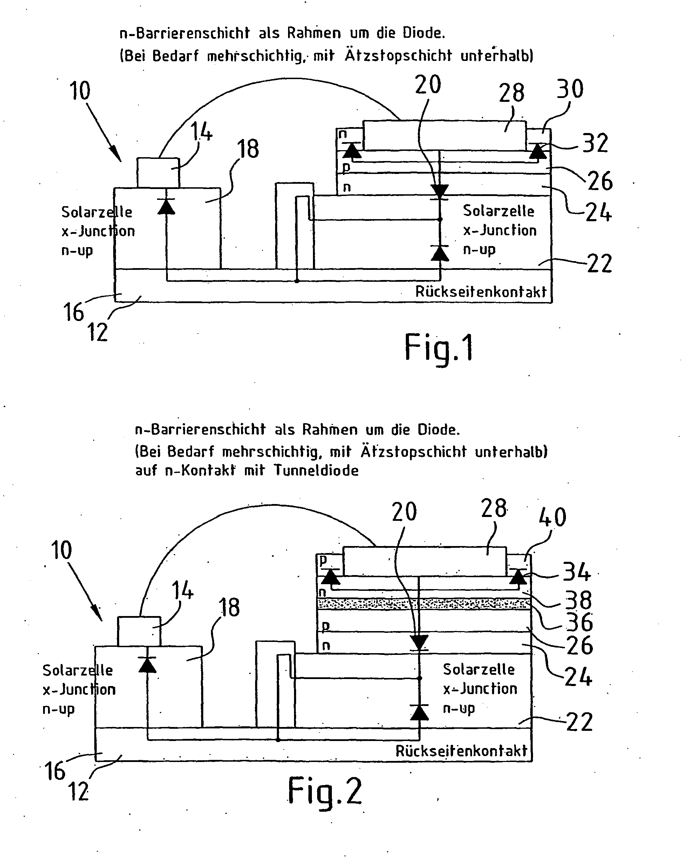

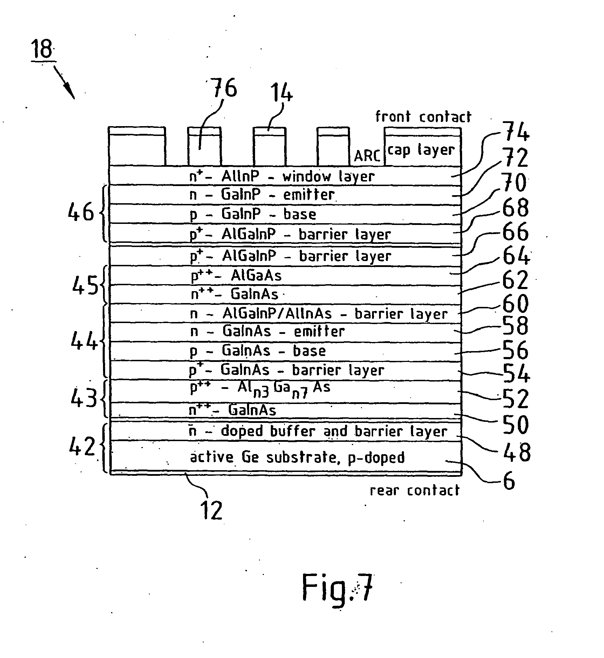

In Fig. 1 ist rein prinzipiell eine Kaskaden- oder Multijunction-Solarzelle 10 des Typs n-up (X-Junction n-up) dargestellt. Die Solarzelle 10 umfasst einen Rückseitenkontakt 12 sowie einen Frontseitenkontakt 14. Zwischen dem Rückseitenkontakt 12 und dem Frontseitenkontakt 14 sind auf einem Germaniumsubstrat 16, das ein p-leitendes einkristallines Germanium sein kann, mehrere Zellen angeordnet, die voneinander durch Tunneldioden getrennt sind. Der so gebildete photoaktive Bereich der Solarzelle 10 ist mit 18 gekennzeichnet. Ein beispielhafter Aufbau des photoaktiven Bereichs 18 einer entsprechenden Solarzelle 10 in Form einer Triple-Zelle ist der Fig. 7 zu entnehmen. Die Schichten der Multijunction-Zelle 10 sind epitaktisch gewachsen.

Vorhandene Mikrokurzschlüsse in den aktiven Halbleiterschichten können bei Betrieb der Solarzelle 10 in Sperrrichtung zu deren Zerstörung führen. Zum Schutz wird eine Schutz- oder Bypassdiode 20 antiparallel zu der Solarzelle 10 bzw. dem aktiven Bereich 18 geschaltet, der von den übereinander angeordneten Subzellen gebildet wird. Hierzu kann entsprechend der Lehre der EP-A-1 056 137 ein kleiner Bereich der photoaktiven Schichten sowie der zwischen diesen verlaufenden Tunneldioden bis zum Substrat 16 zum Beispiel durch lokales vertikales Ätzen entfernt werden. Auf den zu dem photoaktiven Bereich 18 beabstandeten und auf dem Substrat 16 verlaufenden Bereich 22 wird sodann die Schutzdiode 20 des Typs p-up oder p/n epitaktisch aufgetragen, wobei die n-Schicht 24 solarzellenseitig und die p-Schicht 26 frontseitig verläuft.

Die Schutzdiode 20 ist über eine insbesondere Silber enthaltende Metallisierung 28 mit dem Frontseitenkontakt 14 der Solarzelle 10, d. h. dessen aktivem Bereich 18 verbunden.

Gemäß Fig. 1 ist die Metallisierung 28 unmittelbar auf der p-leitenden Schicht 26 der Schutzdiode 20 kontaktiert. Um eine Elektromigration zu vermeiden, d. h. ein Wandern von Metall mit der Stromrichtung von p nach n auf der Oberfläche der Schutzdiode 20, wodurch ein Kurzschluss entstehen könnte, wird auf der p-Schicht 26 eine n-Schicht 30 epitaktisch aufgetragen, die infolgedessen mit der benachbarten p-Schicht 26 einer zu der Schutzdiode 20 entgegengesetzte sperrende Diode 32 bildet. Die Schicht 30 wird dabei in dem Bereich der aufzubringenden Metallisierung 28 entfernt und umgibt vorzugsweise rahmenartig die Metallisierung 28. Durch diese Maßnahme kann der Strom nicht mehr von der Metallisierung 28 über die Oberfläche fließen, sondern nur unter der Metallisierung in die Schutzdiode 20, wodurch eine Elektromigration des Metalls unterbunden wird.

Um die auf der Schutzdiode 20 aufgetragene n-Schicht im Bereich der aufzubringenden Metallisierung 28 zu entfernen, kann in bekannter Weise eine Ätzstoppschicht auf die p-Schicht aufgebracht werden. Bei der Ätzstoppschicht handelt es sich um eine weitere Halbleiterschicht, deren Zusammensetzung von der der frontseitigen n-Schicht 30 abweicht.

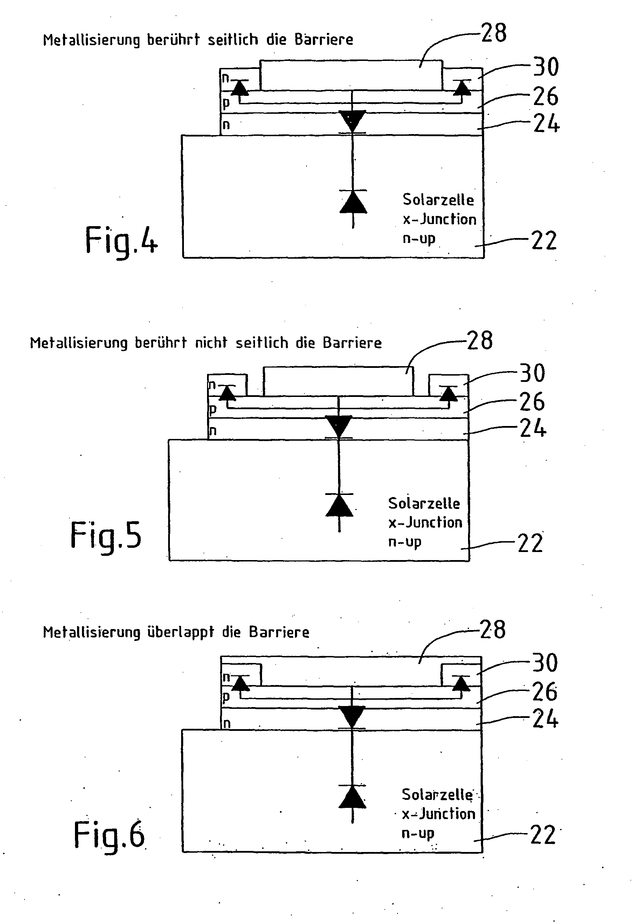

Der auf der p-Schicht 26, also der Schutzdiode 20 verbleibende Bereich der n-Schicht 30 weist eine rahmenartige Struktur auf, die entsprechend der Darstellungen der Fig. 4 - 6 die Metallisierung 28 wie folgt umgeben kann. So kann gemäß Fig. 4 die n-Schicht 30 einen Rahmen bilden, der innenseitig von der Metallisierung 28, d. h. dem Metallkontakt berührt wird. Entsprechend der Fig. 5 besteht auch die Möglichkeit, dass die Metallisierung 28 die die Elektromigrationsbarriere bildende n-Schicht 30 beabstandet.

Als weitere Möglichkeit kann die Metallisierung 28 gemäß Fig. 6 die Barriere, d. h. die n-Schicht 30 frontseitig überlappen bei gleichzeitiger Kontaktierung der Innenflächen der n-Schicht 30.

Der Fig. 2 ist eine der Fig. 1 entsprechende Solarzelle des Typs n-up zu entnehmen, so dass für gleiche Elemente gleiche Bezugszeichen verwendet werden.

Um ebenfalls eine Elektromigration zu unterbinden, die zu einem Kurzschluss in der Schutzdiode 20 führen könnte, wird auf der Schutzdiode 20 eine weitere Diode 34 aufgebracht, die die gleiche Polarität wie die Schutzdiode 20 aufweist. Zwischen der Schutzdiode 20 und der Diode 34 verläuft eine Tunneldiode 36. Die Metallisierung 28 kontaktiert unmittelbar die n-leitende Schicht 38 der Diode 34 und wird peripher von der p-leitenden Schicht 40 der Diode 34 umgeben. Durch die diesbezüglichen Maßnahmen ist erwähntermaßen gleichermaßen eine Elektromigration unterbunden.

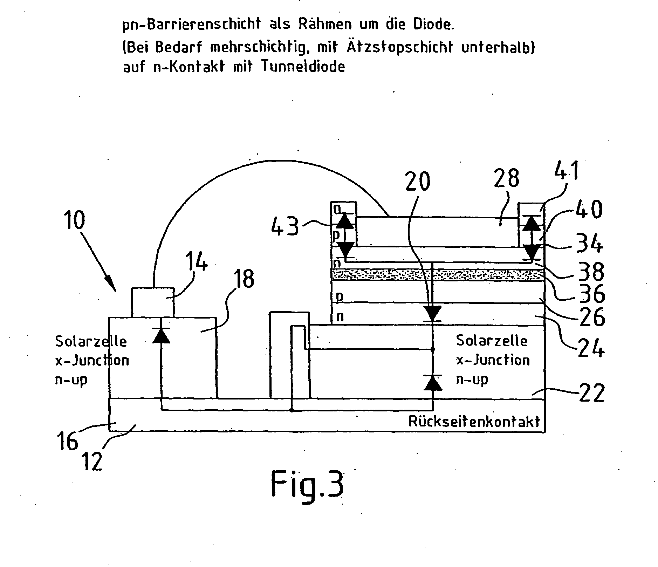

Eine Variation zu der Ausführungsform der Fig. 2 sieht gemäß Fig. 3 vor, dass auf die p-Schicht 40 der zweiten Diode 34 eine weitere n-leitende Schicht 41 aufgetragen wird, die mit der p-Schicht 40 eine zu der zweiten Diode 34 antiparallel geschaltete weitere Diode 43 bildet. Die Diode 43, d. h. die n-Schicht 41 und die p-Schicht 40 bilden die Barriereschicht für die Metallisierung 28.

Bezüglich der Fig. 2 und 3 ist anzumerken, dass die die Migrationsbarrieren bildenden Schichten 40 (Fig. 2) bzw. 40, 41 (Fig. 3) eine Rahmenstruktur bilden, wie dies im Zusammenhang mit der Fig. 1 erläutert wurde. Auch kann sich zu den entsprechenden Barrieren die Metallisierung 28 entsprechend der Fig. 4 - 6 erstrecken. Das Entfernen der Schichten zur Ausbildung der rahmenartig verlaufenden Barrieren kann gleichfalls über Ätzstoppschichten erfolgen, wie dies zuvor erläutert worden ist.

Erfindungsgemäß werden auf die Schutz- oder Bypassdiode 20 eine oder mehrere Schichten epitaktisch aufgetragen, wobei entweder die frontseitige Schicht 26 der Schutzdiode 20 Schicht der weiteren Diode 32 mit der zu der Schutzdiode 20 entgegen gerichteten Polarität ist oder auf der frontseitigen Schicht 26 werden eine Tunneldiode 36 und die weitere Diode 34 epitaktisch aufgetragen, die die gleiche Polarität wie die Schutz- oder Bypassdiode 20 aufweist. Es ist folglich eine gesonderte Schutzdiode für die Bypassdiode 20 vorgesehen.

In Fig. 7 ist der aktive Bereich 18 der Solarzelle 10 am Beispiel einer Triple-Zelle näher erläutert.

Auf den Rückkontakt 12 ist eine Boden- oder Bottomzelle 42 aufgebracht, die sich aus dem p-dotierten aktiven Germaniumsubstrat 16 und auf dieser verlaufenden n-dotierten Buffer- und Barriereschicht 48 zusammensetzt. Auf die Buffer- bzw. Barriereschicht 48 ist sodann eine n⁺⁺-Gallium-Indium-Arsenid (GaInAs)-Schicht 50 oder GaAs-Schicht oder InGaP-Schicht und auf diese eine p⁺⁺-Al_{0,3}Ga_{0,7}As-Schicht 52 aufgetragen, die eine Tunneldiode 43 bilden. Auf die Tunneldiode 43 wird sodann eine Mittelzelle 44 aufgebracht, die sich aus einer p⁺-leitenden Barriereschicht 54 aus GaInAs, einer p-leitenden Basisschicht 56 in Form von GaInAs und einer n-leitenden Emitterschicht 58 in Form von GaInAs zusammensetzt. Der Anteil des Indiums ist dabei so gewählt, dass eine Gitteranpassung an die die Tunneldiode 43 bildenden Schichten erfolgt. Der Anteil von Indium beläuft sich vorzugsweise zwischen 1 % und 3 %.

Die Mittelzelle 44 kann sodann von einer n⁺-leitenden Barriereschicht 60 abgedeckt sein, die aus AlGaInP/AlInAs bestehen kann.

Auf der Mittelzelle 44 erstreckt sich eine Tunneldiode 45 bestehend aus der n⁺⁺-leitenden unteren Schicht 62 aus GaInAs und der p⁺⁺-leitenden oberen Schicht 64 aus AlGaAs. Diese kann sodann von einer Barriereschicht 66 abgedeckt sein, die p⁺-leitend ist und aus AlGaInP besteht.

Auf der Tunneldiode 45 ist eine Front- oder Topzelle 46 epitaktisch aufgetragen, die aus einer p⁺-leitenden Barriereschicht 68 aus GaInP, einer Basisschicht 70, die p-leitend ist und aus GaInP besteht, und einer n-leitenden Emitterschicht 72 aus GaInP zusammensetzt. Die Emitterschicht 72 ist von einer Fensterschicht 74 abgedeckt, die n⁺-leitend ist und aus AlInP besteht. Da die Fensterschicht 74 sich schlecht mit dem Frontkontakt 14 kontaktieren lässt, erstreckt sich abschnittsweise auf der Fensterschicht 74 eine n-leitende Capschicht 76, die aus n-GaAs besteht.

Bezüglich des Schutzdiodenmaterials wird bevorzugterweise dasselbe Material gewählt wie das der Mittelzelle 44, nämlich GaAs mit etwas In. Grundsätzlich könnte auch das Material der Front- oder Topzelle 46, also GaInP benutzt werden. In diesem Fall wäre jedoch die Turn-On-Spannung der Schutzdiode 20 größer. Dies sollte jedoch wegen der auftretenden Verlustleistung vermieden werden.

Die Metallisierung 28, die insbesondere Silber enthält, ist elektrisch leitend sowohl mit dem Frontkontakt 14 des photoaktiven Bereichs 18 als auch mit dem Rückseitenkontakt einer in Serie geschalteten weiteren Solarzelle verbunden.

## Patentansprüche

1. Solarzelle (10) mit Front- und Rückseitenkontakt (12, 14), zwischen diesen verlaufenden photoaktiven Halbleiterschichten sowie einer frontseitig verlaufenden integralen epitaktisch gewachsenen Schutzdiode (20) mit einer zu der Solarzelle entgegen gerichteten Polarität mit einer solarzellenseitig verlaufenden ersten Halbleiterschicht (24) und einer frontseitig verlaufenden zweiten Halbleiterschicht (26) sowie mit einer frontseitig verlaufenden Metallisierung (28), die vorzugsweise mit dem Frontseitenkontakt der Solarzelle verbunden ist,
**dadurch gekennzeichnet,**
**dass** um die Metallisierung (28) der Schutzdiode (20) eine epitaktisch gewachsene Elektromigrationsbarriere (30, 40) ausgebildet ist, in dem entweder
die Metallisierung (28) die Schutzdiode (20) kontaktiert und peripher von einer weiteren Halbleiterschicht (30) umgeben ist, die mit der frontseitig verlaufenden zweiten Halbleiterschicht (26) der Schutzdiode eine zweite Diode (32) mit zu der Schutzdiode entgegen gerichteter Polarität bildet, oder
auf der Schutzdiode (20) eine Tunneldiode (36) angeordnet ist, auf der eine weitere Diode (34) einer Polarität angeordnet ist, die der der Schutzdiode entspricht, wobei die Metallisierung (28) schutzdiodenseitig verlaufende Halbleiterschicht (38) der weiteren Diode kontaktiert und peripher von frontseitig verlaufender Halbleiterschicht (40) der weiteren Diode umgeben ist.

2. Solarzelle nach Anspruch 1,
**dadurch gekennzeichnet,**
**dass** auf die frontseitige Halbleiterschicht (40) der weiteren Diode (34) eine Halbleiterschicht (41) entgegen gesetzter Polarität verläuft.

3. Solarzelle nach Anspruch 1,
**dadurch gekennzeichnet,**
**dass** die weitere Halbleiterschicht (30) n-leitend ist und die Metallisierung (28) rahmenartig umgibt.

4. Solarzelle nach Anspruch 1,
**dadurch gekennzeichnet,**
**dass** die frontseitig verlaufende Halbleiterschicht (40) der weiteren Diode (34) p-leitend ist und die Metallisierung (28) rahmenartig umgibt.

5. Solarzelle nach Anspruch 2,
**dadurch gekennzeichnet,**
**dass** auf der weiteren Diode (34) eine n-leitende Halbleiterschicht (41) verläuft, die mit der unter dieser verlaufenden p-leitenden Schicht (40) die Metallisierung (28) rahmenartig umgibt.

6. Solarzelle nach Anspruch 2,
**dadurch gekennzeichnet,**
**dass** die Metallisierung (28) die n-leitende schutzdiodenseitig verlaufende Halbleiterschicht (38) der weiteren Diode (34) flächig kontaktiert.

7. Solarzelle nach zumindest Anspruch 1,
**dadurch gekennzeichnet,**
**dass** die Solarzelle (10) eine Kaskadensolarzelle insbesondere in Form einer Triple-Zelle mit übereinander epitaktisch gewachsener erster, zweiter und dritter Teilsolarzelle (42, 44, 46) des Typs n/p ist.

8. Solarzelle nach Anspruch 7,
**dadurch gekennzeichnet,**
**dass** photoaktive Schichten der ersten Teilsolarzelle oder Bodenzelle (42) aus Germanium bestehen.

9. Solarzelle nach Anspruch 7,
**dadurch gekennzeichnet,**
**dass** photoaktive Schichten der zweiten Teilsolarzelle oder Mittelzelle (44) aus Ga₁₋ₓInₓAs mit 0,01 ≤ x ≤ 0,03 bestehen.

10. Solarzelle nach zumindest Anspruch 7,
**dadurch gekennzeichnet,**
**dass** photoaktive Schichten der dritten Teilsolarzelle oder Topzelle (46) aus Ga_{1-z}In_{z}P mit 0,48 ≤ z ≤ 0,52 bestehen.

11. Solarzelle nach zumindest Anspruch 7,
**dadurch gekennzeichnet,**
**dass** die Solarzelle (10) aus einem photoaktiven ersten Bereich (18) und einem die Schutzdiode (20) frontseitig aufweisenden zweiten Bereich (22) besteht, wobei der erste Bereich und der zweite Bereich zueinander beabstandet von einem gemeinsamen Substrat (16) ausgehen.

12. Solarzelle nach zumindest Anspruch 1,
**dadurch gekennzeichnet,**
**dass** frontseitig auf der Schutzdiode (20) zumindest eine die Metallisierung zumindest bereichsweise rahmenartig umgebende n-, p- oder pn- Schicht (30; 40; 40, 41) verläuft, die unmittelbar oder über eine oder mehrere Zwischenschichten (36) die Schutzdiode kontaktiert.

13. Solarzelle nach zumindest Anspruch 1,
**dadurch gekennzeichnet,**
**dass** die Metallisierung (28) die rahmenartig verlaufende Elektromigrationsbarriere (30, 40, 41) kontaktiert oder beabstandet zu dieser verläuft.

14. Solarzelle nach zumindest Anspruch 1,
**dadurch gekennzeichnet,**
**dass** sich die Metallisierung (28) zumindest abschnittsweise entlang frontseitigem Bereich der rahmenartig verlaufenden Elektromigrationsbarriere (30, 40, 41) erstreckt.

## Claims

1. Solar cell (10) with front and rear contacts (12, 14), photoactive semiconductor layers running between said contacts and an integral epitaxially grown protection diode (20) on the front having a polarity opposite to the solar cell with a first semiconductor layer (24) on the solar cell side and a second semiconductor (26) on the front side and with a metallized portion (28) on the front side that is preferably connected to the front contact of the solar cell,
wherein
an epitaxially grown electromigration barrier (30, 40) is formed around the metallized portion (28) of the protection diode (20), in which either the metallized portion (28) contacts the protection diode (20) and is surrounded peripherally by a further semiconductor layer (30) forming with the second front-side semiconductor layer (26) of the protection diode a second diode (32) with polarity opposite to the protection diode,
or a tunnel diode (36) is arranged on the protection diode (20), on which tunnel diode a further diode (34) is arranged with a polarity corresponding to that of the protection diode, where the metallized portion (28) contacts the protection diode-side semiconductor layer (38) of the further diode and is surrounded peripherally by a front-side semiconductor layer (40) of the further diode.

2. Solar cell according to Claim 1,
wherein
a semiconductor layer (41) of opposite polarity runs on the front-side semiconductor layer (40) of the further diode (34).

3. Solar cell according to Claim 1,
wherein
the further semiconductor layer (30) is n-conducting and surrounds the metallized portion (28) like a frame.

4. Solar cell according to Claim 1,
wherein
the front-side semiconductor layer (40) of the further diode (34) is p-conducting and surrounds the metallized portion (28) like a frame.

5. Solar cell according to Claim 2,
wherein
an n-conducting semiconductor layer (41) surrounding the metallized portion (28) like a frame with the p-conducting layer (40) running underneath it runs on the further diode (34).

6. Solar cell according to Claim 2,
wherein
the metallized portion (28) is in surface contact with the n-conducting protection diode-side semiconductor layer (38) of the further diode (34).

7. Solar cell according to at least Claim 1,
wherein
the solar cell (10) is a cascade solar cell in particular in the form of a triple cell with first, second and third partial solar cells (42, 44, 46) of the n/p type grown epitaxially one above the other.

8. Solar cell according to Claim 7,
wherein
photoactive layers of the first partial solar cell or bottom cell (42) comprise germanium.

9. Solar cell according to Claim 7,
wherein
photoactive layers of the second partial solar cell or middle cell (44) comprise Ga₁₋ₓInₓAs with 0.01 ≤ x ≤ 0.03.

10. Solar cell according to at least Claim 7,
wherein
photoactive layers of the third partial solar cell or top cell (44) comprise Ga_{1-z}In_{z}P with 0.48 ≤ z ≤ 0.52.

11. Solar cell according to at least Claim 7,
wherein
the solar cell (10) comprises a photoactive first area (18) and a second area (22) having the protection diode (20) on the front, with the first area and the second area extending from a common substrate (16) at a distance from one another.

12. Solar cell according to at least Claim 1,
wherein
on the front side of the protection diode (20) runs at least one n, p or pn layer (30; 40; 40, 41) surrounding the metallized portion like a frame at least in some areas and contacting the protection diode directly or via one or more intermediate layers (36).

13. Solar cell according to at least Claim 1,
wherein
the metallized portion (28) contacts the frame-like electromigration barrier (30, 40, 41) or runs at a distance thereto.

14. Solar cell according to at least Claim 1,
wherein
the metallized portion (28) extends at least in some sections along a front-side area of the frame-like electromigration barrier (40, 40, 41).

## Revendications

1. Cellule solaire (10) avec contacts avant et arrière (12, 14), entre lesquels s'étendent des couches semi-conductrices photoactives ainsi qu'une diode de protection (20) intégralement épitaxiée s'étendant du côté avant avec une polarité opposée à celle de la cellule solaire, avec une première couche semi-conductrice (24) s'étendant du côté de la cellule solaire et une deuxième couche semi-conductrice (26) s'étendant du côté avant, ainsi qu'avec une métallisation (28) s'étendant du côté avant et de préférence reliée au contact avant de la cellule solaire,
**caractérisée en ce**
**qu'**autour de la métallisation (28) de la diode de protection (20) est formée une barrière de migration électrique épitaxiée (30, 40), sachant que ou bien la métallisation (28) contacte la diode de protection (20) et est périphériquement entourée par une couche semi-conductrice supplémentaire (30) qui, avec la deuxième couche semi-conductrice (26) de la diode de protection s'étendant du côté avant, forme une deuxième diode (32) avec une polarité opposée à celle de la diode de protection, ou bien
**que** sur la diode de protection (20) est placée une diode tunnel (36) sur laquelle est disposée une diode supplémentaire (34) d'une polarité correspondant à celle de la diode de protection, sachant que la métallisation (28) contacte la couche semi-conductrice (38) de la diode supplémentaire s'étendant du côté de la diode de protection et est périphériquement entourée par la couche semi-conductrice (40) de la diode supplémentaire s'étendant du côté avant.

2. Cellule solaire selon la revendication 1,
**caractérisée en ce**
**qu'**une couche semi-conductrice (41) de polarité opposée s'étend sur la couche semi-conductrice (40) du côté avant de la diode supplémentaire (34).

3. Cellule solaire selon la revendication 1,
**caractérisée en ce**
**que** la couche semi-conductrice supplémentaire (30) est à conduction de type n et entoure la métallisation (28) à la manière d'un cadre.

4. Cellule solaire selon la revendication 1,
**caractérisée en ce**
**que** la couche semi-conductrice (40) de la diode supplémentaire (34) s'étendant du côté avant est à conduction de type p et entoure la métallisation (28) à la manière d'un cadre.

5. Cellule solaire selon la revendication 2,
**caractérisée en ce**
**que** sur la diode supplémentaire (34) s'étend une couche semi-conductrice (41) à conduction de type n qui, avec la couche (40) à conduction de type p s'étendant sous celle-ci, entoure la métallisation (28) à la manière d'un cadre.

6. Cellule solaire selon la revendication 2,
**caractérisée en ce**
**que** la métallisation (28) contacte surfaciquement la couche semi-conductrice (38) à conduction de type n de la diode supplémentaire (34) s'étendant du côté de la diode de protection.

7. Cellule solaire selon au moins la revendication 1,
**caractérisée en ce**
**que** la cellule solaire (10) est une cellule solaire en cascade en particulier sous forme de cellule triple avec une première, une deuxième et une troisième cellules solaires partielles du type n/p (42, 44, 46) épitaxiées et superposées.

8. Cellule solaire selon la revendication 7,
**caractérisée en ce**
**que** les couches photoactives de la première cellule solaire partielle, ou cellule inférieure (42), sont constituées de germanium.

9. Cellule solaire selon la revendication 7,
**caractérisée en ce**
**que** les couches photoactives de la deuxième cellule solaire partielle, ou cellule médiane (44), sont constituées de Ga₁₋ₓInₓAs, avec 0,01 ≤ x ≤ 0,03.

10. Cellule solaire selon au moins la revendication 7,
**caractérisée en ce**
**que** les couches photoactives de la troisième cellule solaire partielle, ou cellule supérieure (46), sont constituées de Ga_{1-z}In_{z}P, avec 0,48 ≤ z ≤ 0,52.

11. Cellule solaire selon au moins la revendication 7,
**caractérisée en ce**
**que** la cellule solaire (10) est constituée d'une première zone photoactive (18) et d'une deuxième zone (22) présentant la diode de protection (20) du côté avant, sachant que la première zone et la deuxième zone sortent d'un substrat commun (16) à une certaine distance l'une de l'autre.

12. Cellule solaire selon au moins la revendication 1,
**caractérisée en ce**
**que** du côté avant sur la diode de protection (20) s'étend au moins une couche (30 ; 40 ; 40, 41) de type n, p ou pn entourant au moins sectoriellement la métallisation à la manière d'un cadre et qui contacte la diode de protection directement ou par l'intermédiaire d'une ou plusieurs couche(s) intermédiaire(s) (36).

13. Cellule solaire selon au moins la revendication 1,
**caractérisée en ce**
**que** la métallisation (28) contacte la barrière de migration électrique (30, 40, 41) s'étendant à la manière d'un cadre • ou s'étend à une certaine distance de celle-ci.

14. Cellule solaire selon au moins la revendication 1,
**caractérisée en ce**
**que** la métallisation (28) s'étend au moins sectoriellement le long de la zone du côté avant de la barrière de migration électrique (30, 40, 41) s'étendant à la manière d'un cadre.
